# EUROPÄISCHE PATENTANMELDUNG

(11) **EP 3 096 458 A1**
(43) Veröffentlichungstag der Anmeldung: **23.11.2016**
(21) Anmeldenummer: 16167840.4
(22) Anmeldetag: 02.05.2016
(51) Int. Cl.: H03K 17/96

(54) **STEUEREINRICHTUNG FÜR DIE STEUERUNG VON ELEKTRISCHEN HAUSGERÄTEN**

(30) Priorität: 20.05.2015 DE 102015107944
(71) Anmelder: Miele & Cie. KG, 33332 Gütersloh (DE)
(72) Erfinder: Beier, Dominic, 33332 Gütersloh (DE); Wienströer, Reinard, 33803 Steinhagen (DE)

(57) **Zusammenfassung**

Die Erfindung betrifft eine Steuereinrichtung für die Steuerung von elektrischen Hausgeräten, mit einer Bedien- und Anwahlvorrichtung (5) mittels der die Funktionen des Gerätes in Verbindung mit einer elektronischen Steuereinheit (4) steuerbar sind.

Erfindungsgemäß ist vorgesehen, dass die Bedien- und Anwahlvorrichtung (5) Oberflächenwellen-Bauelemente (91 bis 9n) aufweist, die mit der elektronischen Steuereinheit (4) signaltechnisch in Verbindung stehen, und dass die elektronische Steuereinheit (4) ein Sendemodul zur Erzeugung und Aussendung hochfrequenter, elektromagnetischer Sendesignale (7) sowie ein Empfangs- und Auswertemodul für die Erfassung der von den Oberflächenwellen-Bauelementen (91 bis 9n) ausgehenden Antwortsignale (8) umfasst.

Durch die Erfindung wird der Vorteil erzielt, dass die verwendeten Oberflächenwellen-Bauelemente mit einer Hochfrequenz-Ansteuerung auf passiver Basis arbeiten, so dass sie für die drahtlose Signalübertragung keine Hilfsenergie beispielsweise durch eine Batterie oder einen Akkumulator benötigen.

## Beschreibung

Die Erfindung betrifft eine Steuereinrichtung für die Steuerung von elektrischen Hausgeräten mit einer Bedien- und Anwahlvorrichtung, mittels der die Funktionen des Gerätes in Verbindung mit einer elektronischen Steuereinheit steuerbar sind.

Bei Hausgeräten sind Bedienvorrichtungen in vielfältigen Ausführungsformen im praktischen Einsatz. Weit verbreitet ist dabei die Verwendung von Eingabetasten, die mechanisch auf Fingerdruck oder berührungssensitiv auf kapazitiver Basis reagieren. Weiterhin gehen Bestrebungen dahin, die Eingabetechnik für das Steuern von Haushaltsgeräten mit drahtlosen Signal-übertragungen weiterzuentwickeln.

So wird zum Beisp. in der DE 299 22 728 U1 eine Steuereinrichtung für eine Dunstabzugshaube beschrieben, bei der neben der üblichen Bedientastatur am Gerät parallel dazu eine drahtlose Signalstrecke vorgesehen sein soll, über die per Fernsteuerung ebenfalls Steuerbefehle an das Gerät übertragen werden können.
Weiterhin wird in der DE 299 19 452 U1 vorgeschlagen, eine Dunstabzugshaube mit einer berührungslosen Schaltsensorik auszurüsten, die an Stelle einer Fernsteuerung eine Sensorik mit einem Bewegungsmelder für die Einschaltung der Dunstabzugshaube verwendet.
Die im vorgenannten Stand der Technik beschriebenen Ausführungsformen sind sehr aufwändig gestaltet und haben sich in dieser Form in der Praxis bei einer Dunstabzugshaube nicht durchgesetzt.

Auch bei im Haushaltsbereich eingesetzte Bodenstaubsaugern ist die Anwendung von Steuerungen per Funkübertragung allgemein bekannt. So wird zum Beispiel in der DE 10 2013 109 321 A1 eine Handgriffsteuerung beschrieben, bei der über einen im Handgriff angeordneten Drucktastenschalter und über ein Funkmodul das im Gerätegehäuse untergebrachte Gebläse durch eine drahtlose Signalübertragung gesteuert werden kann.

Alle bislang für Haushaltsgeräte vorgesehenen Ausführungsformen sind mit dem Nachteil behaftet, dass sie für die drahtlose Signalübertragung von der Bedien- und Anwahlvorrichtung zur elektronischen Steuereinrichtung des Gerätes immer eine Hilfsenergiequelle, wie beispielsweise eine Batterie, benötigen.

Der Erfindung stellt sich somit das Problem, für elektrische Hausgeräte der eingangs genannten Art eine Steuereinrichtung mit einer Bedien- und Anwahlvorrichtung bereitzustellen, bei der mit einfachen Mitteln eine drahtlose Übertragung der Eingabebefehle zur Steuerung der Gerätefunktionen verwirklicht werden kann.

Erfindungsgemäß wird dieses Problem durch eine Steuereinrichtung mit den Merkmalen des Patentanspruchs 1 gelöst. Vorteilhafte Ausgestaltungen und Weiterbildungen der Erfindung ergeben sich aus den nachfolgenden Unteransprüchen.

Der Gegenstand der Erfindung beruht auf dem Gedanken, die aus dem einschlägigen Stand der Technik bekannten Oberflächenwellen-Bauelemente in einer neuartigen Verwendungsart für die Realisierung einer drahtlosen Tastatur in Hausgeräten einzusetzen. Es wurde zwar bereits vorgeschlagen und in der Praxis realisiert, Oberflächenwellen-Bauelemente als Temperatursensoren in einem Temperaturspieß für in Backöfen zu garendes Gargut zu verwenden (EP1 708 540 B1 - Miele). Auch wurden mehrfach Vorschläge veröffentlicht, bei denen Oberflächenwellen-Bauelemente zur Temperatursensierung bei einem Kochgeschirr für elektrische Herde eingesetzt werden sollen (u.a. DE 198 28 170 A1). Jedoch ist bislang nicht bekannt, Oberflächenwellen-Bauelemente in der erfindungsgemäß vorgeschlagenen Verwendungsweise zu nutzen.

Die mit der Erfindung erreichbaren Vorteile sind insbesondere darin zusehen, dass Oberflächenwellen-Bauelemente mit einer Hochfrequenz-Ansteuerung auf passiver Basis arbeiten. Das bedeutet, dass sie gegenüber anderen drahtlosen Tastaturen keine Hilfsenergie, zum Beispiel durch eine Batterie oder einen Akkumulator, benötigen. Außerdem ist es nicht notwendig aktive Bauelemente innerhalb der Tastatur der Bedienvorrichtung einzusetzen, um eine Abfrage der Tasten oder die Rückübertragung der Tasteninformation per Funk zu realisieren.

In einer für die praktische Realisierung zweckmäßig ausgebildeten Ausführungsform ist vorgesehen, dass die Oberflächenwellen-Bauelemente parallel geschaltet sind, und dass jedem Oberflächenwellen-Bauelement ein Schaltelement zugeordnet wird, wodurch das jeweils angewählte Oberflächenwellen-Bauelement signaltechnisch aktiviert und mit der elektronischen Steuereinheit verbunden werden kann. Das Schaltelement ist dabei als funktionales Mittel zur Verbindung oder Trennung von miteinander zusammenwirkenden Bauelementen u sehen, es kann sich daher um einen kontaktbehafteten Schalter handeln oder um eine kontaktlose Vorrichtung, wie ein kapazitiv wirkendes Bauteil, mit dem eine Änderung einer elektrischen Größe bewirkt wird.

Die Schaltelemente sind dabei in einer in der Bedien- und Anwahlvorrichtung gebildeten Tastatur integriert. Dabei können Schaltelemente verwendet werden, die mechanisch auf Fingerdruck reagieren oder durch Berührung nach dem kapazitiven Schaltprinzip arbeiten.

Die Oberflächenwellen-Bauelemente können für den Signalempfang und für die Signalaussendung über die Schaltelemente an eine gemeinsame Antenne oder jeweils an eine separate Antenne angeschlossen werden.

In vorteilhaften und zweckmäßig gestalteten Ausführungsformen können als Oberflächenwellen-Bauelemente Zweitor-Resonatoren mit unterschiedlicher Resonanzfrequenz oder Laufzeitelemente mit unterschiedlichen Codierungen, das bedeutet, dass hierbei unterschiedlich angeordnete Reflektoren verwendet werden.

Der Gegenstand der Erfindung lässt sich insbesondere in Hausgeräten verwirklichen, bei denen die elektronische Gerätesteuerung und die Bedientastatur relativ nah zueinander im Gehäuse des Gerätes platziert sind, so dass eine einwandfreie Signalübertragung möglich ist.

So lassen sich die erfindungsgemäßen Ausgestaltungen besonders vorteilhaft bei einer Dunstabzugshaube einsetzen. Prädestiniert dazu ist hierbei beispielsweise eine Dunstabzugshaube, bei der der Haubenkörper als Glasschirm ausgebildet ist und die Eingabetastatur mit einer Hilfsenergiequelle für die drahtlose Fernsteuerung optisch stören würde und in sinnvoller Weise in dem Glasschirm nicht untergebracht werden kann.

Ein weiteres vorteilhaftes Anwendungsgebiet sind auch Bodenstaubsauger, beispielsweise mit einer Handgriffsteuerung, mit der der Gebläsemotor vom Handgriff aus durch eine drahtlose Signalübertragung gesteuert werden soll. Überall dort, wo es zweckmäßig und sinnvoll erscheint, sind der Übertragung der erfindungsgemäßen Ausführung auf elektrische Hausgeräte jeglicher Art keine Grenzen gesetzt.

Ein Ausführungsbeispiel der Erfindung ist in den Zeichnungen rein schematisch dargestellt und wird nachfolgend näher beschrieben. Es zeigt
- Figur 1: eine Dunstabzugshaube üblicher Bauart in einer Vorderansicht;
- Figur 2: dass Schaltbild einer ersten Ausführungsform für die Anwendung von Oberflächenwellen-Bauelementen mit mechanisch betätigbaren Schaltkontakten;
- Figur 3: ein Prinzipschaltbild für eine Ausführungsform mit einem auf kapazitiver Basis arbeitenden Tastaturelement für die Ansteuerung der OberflächenwellenBauelemente bzw. zur Beeinflussung der Resonanzfrequenz eines Oberflächenwellen-Bauelements.

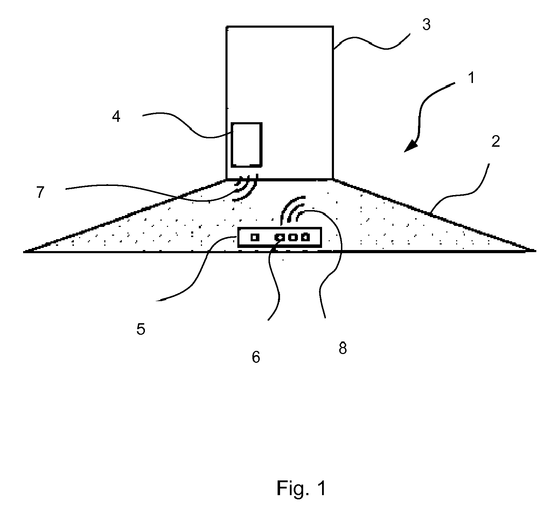

In der Figur 1 ist eine Dunstabzugshaube 1 in üblicher Bauart dargestellt. Die Dunstabzugshaube 1 besteht hier im Wesentlichen aus dem Haubenkörper 2 und dem Schachtkörper 3. Im Haubenkörper 2 sind in der Regel das Motorgebläse und das Filterelement untergebracht, die in dieser Zeichnung aber nicht im Einzelnen dargestellt sind. In der hier gezeigten Version ist der Haubenkörper 2 als Glasschirm ausgebildet, auf dessen Frontfläche die Bedien- und Anwahlvorrichtung 5 mit ihren Bedientasten 6 platziert ist.

Die elektronische Steuereinheit 4 des Gerätes ist bei diesem Ausführungsbeispiel in dem Schachtkörper 3 angeordnet. In der Zeichnung sind hier die von der Steuereinheit 4 ausgehenden Sendesignale 7 und die von den Oberflächenwellen-Bauelementen 9 abgegebenen Antwortsignale 8 angedeutet, wenn die Steuereinheit 4 mit einem der aktivierten Oberflächenwellen-Bauelementen 9 signaltechnisch verbunden ist, worauf nachstehend noch näher eingegangen wird.

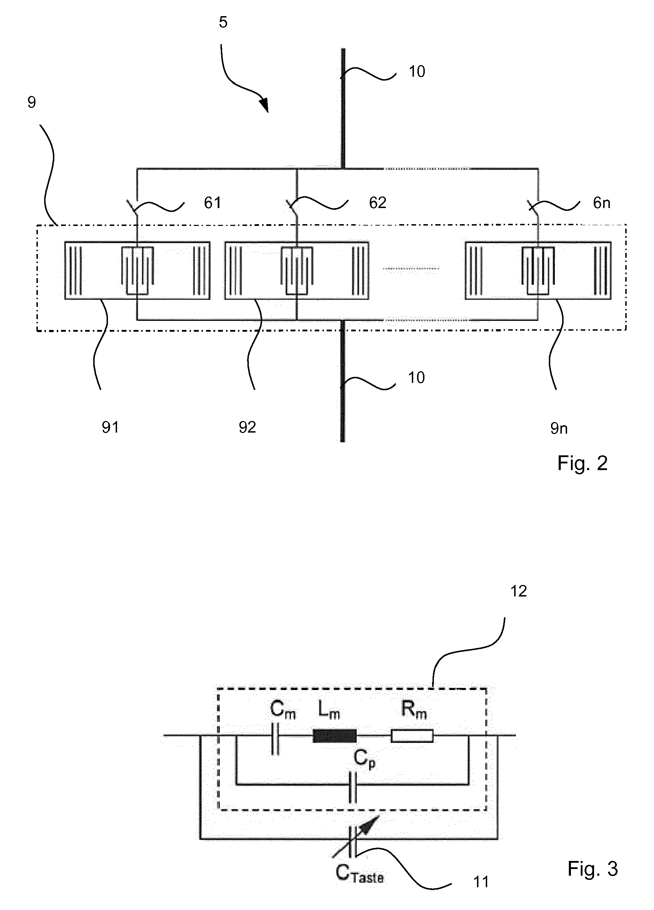

In der in Figur 2 gezeigten ersten Ausführungsform umfasst die Bedien- und Anwahlvorrichtung 5 neben den Oberflächenwellen-Bauelementen 9 eine Tastatur mit Bedientasten 6, die mechanisch betätigbare Schaltelemente 61 bis 6n aufweisen, sowie eine Antenne 10, über die von der Steuereinheit 4 ausgehende Sendesignale 7 aufgenommen und Antwortsignale 8 der Oberflächenwellen-Bauelemente 9 zurück an die Steuereinheit 4 übertragen werden können. Die Funktion der in Figur 2 dargestellten Ausführungsform ist wie folgt:

Über die Bedientasten 6 der Bedien- und Anwahlvorrichtung 5 können vom Benutzer in üblicher Form die gewünschten Funktionen des Gerätes ausgewählt werden. Bei Betätigung einer Bedientaste 6 wird jeweils ein Oberflächenwellen-Bauelement 91 bis 9n über das entsprechende Schaltelement 61 bis 6n mit der Antenne 10 verbunden und ist damit signaltechnisch aktiviert.

Die Oberflächenwellen-Bauelemente können für den Signalempfang und für die Signalaussendung über die Schaltelemente an eine gemeinsame Antenne oder jeweils an eine separate Antenne angeschlossen werden.

Das grundsätzliche Funktionsprinzip von Oberflächenwellen-Bauelementen ist aus dem einschlägigen Stand der Technik allgemein bekannt. Im vorliegenden Fall werden zur regelmäßigen Abfrage der als Bedienelemente dienenden Schaltelemente 61 bis 6n durch ein in der Steuereinheit 4 implementiertes Sendemodul hochfrequente, elektromagnetische Erregerwellen erzeugt, die in Figur 1 als Sendesignal 7 symbolisch angedeutet sind. Die Erregerwellen bewirken, dass beim Betätigen eines der Schaltelemente 61 das ausgewählte Oberflächenwellen-Bauelement 91 bis 9n an die Antenne angeschaltet und zum Schwingen angeregt wird, wodurch von diesem Oberflächenwellen-Bauelement wiederum Antwortwellen erzeugt werden. Durch diese Antwortwellen wird ein vom Oberflächenwellen-Bauelement 9 ausgehendes, hochfrequentes Antwortsignal 8 hervorgerufen. Dieses Antwortsignal 8 wird von einem Empfangs- und Auswertemodul in der elektronischen Steuereinheit 4 erfasst und identifiziert, wodurch dann die gewünschte Funktion oder die ausgewählte Programmanwahl für die Dunstabzugshaube 1 ausgelöst wird.

In einer vorteilhaften Ausführungsform sind als Oberflächenwellen-Bauelemente 9 Zweitor-Resonatoren vorgesehen, die mit unterschiedlichen Resonanzfrequenzen eingestellt werden. Die Verwendung dieser Zweitor-Resonatoren bietet den Vorteil, dass neben mechanisch arbeitenden Schaltelementen, wie Tasten, auch berührungssensitiv wirkende, kapazitive Tastenflächen abgefragt werden können. In der Figur 3 ist ein Ausführungsbeispiel dargestellt, bei dem für die Auswahl des jeweiligen Oberflächenwellen-Bauelementes 9 ein kapazitiv wirkendes Schaltelement 11 vorgesehen ist. In dieser Zeichnung ist der in Frage kommende Zweitor-Resonator durch eine Ersatzschaltung 12 symbolisiert, der bei Betätigung des Schaltelementes 11 bezüglich seiner Resonanzfrequenz verstimmt wird. Vereinfacht ausgedrückt, wird bei der Verwendung von Zweitor-Resonatoren jeder Resonator durch die zugehörige Bedientaste 11 im Schwingverhalten verändert.

Wie in Figur 2 dargestellt, können mehrere Oberflächenwellen-Bauelemente 91 bis 9n parallel über entsprechende Schaltelemente 61 - 6n an die gemeinsame Antenne 10 angeschlossen werden, wobei nur die Elemente 91 bis 9n schwingen und antworten, die durch ihr zugehöriges Schaltelement 61 bis 6n ausgewählt wurden. Alternativ kann für jedes Oberflächenbauelement 91 bis 9n jeweils eine eigene, also separate Antenne zugeordnet sein (nicht dargestellt), sodass hinsichtlich der räumlichen Anordnung der einzelnen Bedientasten 61 bis 6n in Verbindung mit den jeweils zugeordneten Oberflächenbauelementen 91 bis 9n nahezu keine Einschränkungen bzw. große Freiheitsgrade erreicht werden.

Durch eine Fourieranalyse des Antwortsignals oder ein vergleichbares Verfahren kann aus dem Frequenzspektrum ermittelt werden, welche Bedientaste 6 zum Zeitpunkt der Anregung betätigt wurde. Die Verwendung von Zweitor-Resonatoren bildet zudem den Vorteil, dass neben herkömmlichen Tasten auch berührungssensitiv wirkende, kapazitive Tastflächen abgefragt werden können. Im einfachsten Fall wird dies durch die Kapazitätsänderung bei Berührung der Bedientaste durch Parallelschaltung zum Resonator genutzt, um die Resonanz des Oberflächenelementes in einem definierten Frequenzbereich zu verändern (s. Figur 3). Diese Änderung kann wiederum mittels Fourieranalyse des Antwortsignals detektiert werden.

Als weitere Möglichkeit bieten sich als Oberflächenwellen-Bauelemente 9 so genannte Laufzeitelemente bzw. Verzögerungsleitungen an. Bei dieser Art von Oberflächenwellen-Bauelementen werden die über eine Antenne empfangenen, elektromagnetischen Wellen in Oberflächenwellen gewandelt. Die Wellen wandern über das Element, werden an einem oder an mehreren Reflektoren auf der Oberfläche des Elementes reflektiert und nach nochmaligen Wandern über das Element von der Antenne 10 wieder abgestrahlt. Da die Ausbreitungsgeschwindigkeit der Oberflächenwelle nur ca. das 1/100.000-fache der elektromagnetischen Signalwelle beträgt, kann das Antwortsignal mit deutlicher Verzögerung nach Abschaltung der Anregung sensiert werden. Durch Verwendung von Bauelementen mit unterschiedlichen Laufzeiten oder Codierungen (mehrere Reflektoren in unterschiedlichen Abständen) können mehrere Bedientasten durch eine entsprechende Verschaltung abgefragt werden.

### Bezugszeichenliste:

- 1.: Dunstabzugshaube
- 2.: Haubenkörper, Glasschirm
- 3.: Schachtkörper
- 4.: Steuereinheit
- 5.: Bedien- und Anwahlvorrichtung, Bedienfeld
- 6.: Bedientasten
61 Schaltelement
62 Schaltelement
6n Schaltelement
- 7.: Sendesignal, in Form von Erregerwellen
- 8.: Antwortsignal, in Form von Antwortwellen
- 9.: Oberflächenwellen-Bauelemente
91 Oberflächenwellen-Bauelement
92 Oberflächenwellen-Bauelement
9n Oberflächenwellen-Bauelement
- 10.: Antenne
- 11.: kapazitives Schaltelement
- 12.: Ersatzschaltung, Zweitor-Resonator

## Patentansprüche

1. Steuereinrichtung für die Steuerung von elektrischen Hausgeräten mit einer Bedien- und Anwahlvorrichtung (5) mittels der die Funktionen des Gerätes in Verbindung mit einer elektronischen Steuereinheit (4) steuerbar sind,
**dadurch gekennzeichnet,**
**dass** die Bedien- und Anwahlvorrichtung (5) Oberflächenwellen-Bauelemente (9) aufweist, die mit der elektronischen Steuereinheit (4) signaltechnisch in Verbindung stehen, dass die elektronische Steuereinheit (4) ein Sendemodul zur Erzeugung und Aussendung hochfrequenter elektromagnetischer Sendesignale (7) sowie ein Empfangs- und Auswertemodul für die Erfassung der von den Oberflächenwellen-Bauelementen (9) ausgehenden Antwortsignale (8) umfasst.

2. Steuereinrichtung nach Anspruch 1,
**dadurch gekennzeichnet,**
**dass** die Oberflächenwellen-Bauelemente (91 bis 9n) parallel geschaltet sind, und dass jedem Oberflächenwellen-Bauelement (91 bis 9n) ein Schaltelement (61 bis 6n) zugeordnet ist, wodurch das jeweils angewählte Oberflächenwellen-Bauelement (91 bis 9n) signaltechnisch mit der elektronischen Steuereinheit (4) verbunden werden kann.

3. Steuereinrichtung nach Anspruch 1,
**dadurch gekennzeichnet,**
**dass** den Oberflächenwellen-Bauelementen (91 bis 9n) jeweils an eine separate Antenne (10) zugeordnet ist und/oder an diesen angeschlossen sind.

4. Steuereinrichtung nach Anspruch 2,
**dadurch gekennzeichnet,**
**dass** die Schaltelemente (61 bis 6n) in einer Bedien- und Anwahlvorrichtung (5) integriert sind, die eine Tastatur mit Bedientasten (6) aufweist.

5. Steuereinrichtung nach Anspruch 4,
**dadurch gekennzeichnet,**
**dass** nach dem mechanischen oder kapazitiven Schaltprinzip arbeitende die Schaltelemente (61 bis 6n) eingesetzt werden.

6. Steuereinrichtung nach einem oder mehreren der vorhergehenden Ansprüche 1 bis 5,
**dadurch gekennzeichnet,**
**dass** die Oberflächenwellen-Bauelemente (91 bis 9n) für den Signalempfang und für die Signalaussendung über die Schaltelemente (61 bis 6n) an eine gemeinsame Antenne (10) angeschlossen werden können.

7. Steuereinrichtung nach einem oder mehreren der vorhergehenden Ansprüche 1 bis 5,
**dadurch gekennzeichnet,**
**dass** die Oberflächenwellen-Bauelemente (91 bis 9n) für den Signalempfang und für die Signalaussendung über die Schaltelemente (61 bis 6n) jeweils an eine separate Antenne (10) angeschlossen werden können.

8. Steuereinrichtung nach einem oder mehreren der vorhergehenden Ansprüche 1 bis 7,
**dadurch gekennzeichnet,**
**dass** als Oberflächenwellen-Bauelemente (91 bis 9n) Zweitor-Resonatoren mit unterschiedlicher Resonanzfrequenz oder Laufzeitelemente mit unterschiedlichen Codierungen verwendet werden.
